# FASCICULE DE BREVET EUROPEEN

(11) **EP 3 009 896 B1**
(45) Date de publication et mention de la délivrance du brevet: **11.03.2020**
(21) Numéro de dépôt: 15184492.5
(22) Date de dépôt: 09.09.2015
(51) Int. Cl.: G04D 3/00, G04B 43/00, G04B 13/02, B81C 1/00

(54) **PIÈCE MONOBLOC EN MÉTAL ÉLECTROFORMÉ**
ELEKTROGEFORMTES MONOBLOCK-METALLTEIL
INTEGRAL PART MADE OF ELECTROFORMED METAL

(30) Priorité: 17.10.2014 EP 14189332
(43) Date de publication de la demande: 20.04.2016
(73) Titulaire: Nivarox-FAR S.A., 2400 Le Locle (CH)
(72) Inventeur: Dubois, Philippe, 2074 Marin (CH); Charbon, Christian, 2054 Chézard-St-Martin (CH)
(74) Mandataire: Goulette, Ludivine

(56) Documents cités:
- EP-A1- 2 065 107
- CH-A2- 706 653
- US-A1- 2003 094 215
- US-A1- 2013 105 454
- US-A1- 2014 003 203

## Description

### Domaine de l'invention

L'invention se rapporte à une pièce monobloc en métal électroformé et notamment une telle pièce comportant une résistance à l'usure améliorée.

### Arrière-plan de l'invention

Il est connu de former des pièces métalliques monoblocs à l'aide d'un processus LIGA, c'est-à-dire un processus mêlant la formation d'un moule par exemple par photolithographie avec le remplissage dudit moule à l'aide d'une galvanoplastie.

Toutefois, ces pièces électroformées sont généralement trop molles et possèdent une résistance à l'usure non satisfaisante.

Le document EP 2 586 880 décrit qu'un durcissement localisé peut être obtenu en chauffant, à l'aide d'un faisceau laser, uniquement sur la partie de la pièce électroformée à durcir à cœur sans modifier le reste de la pièce.

### Résumé de l'invention

Le but de la présente invention est de pallier tout ou partie les inconvénients cités précédemment en proposant une pièce monobloc électroformée dont la résistance à l'usure est améliorée tout en conservant une perméabilité magnétique relative inférieure à 10 et la possibilité d'être chassée ainsi qu'un procédé de fabrication comportant une étape de durcissement superficielle dont la profondeur est facilement contrôlable.

A cet effet, l'invention se rapporte à une pièce monobloc comportant un corps en métal électroformé comportant de l'hydrogène emprisonné caractérisée en ce que toute la surface externe du corps comporte, uniquement sur une profondeur comprise entre 0,1% et 10% de l'épaisseur totale de la pièce monobloc, un appauvrissement en hydrogène emprisonné apportant un durcissement par rapport au reste du corps afin d'améliorer la résistance à l'usure de la pièce monobloc tout en conservant une perméabilité magnétique relative inférieure à 10 et la possibilité d'être chassée.

Ainsi, de manière surprenante, un tel durcissement superficiel du corps en métal électroformé permet avantageusement selon l'invention, d'améliorer la résistance à l'usure de la pièce monobloc tout en conservant une perméabilité magnétique relative inférieure à 10 tout en gardant la possibilité d'être chassée.

Conformément à d'autres variantes avantageuses de l'invention :
- le métal est électroformé sous forme amorphe et la surface externe comporte une phase au moins partiellement cristalline du métal électroformé ou une taille de grains supérieure au métal électroformé du reste du corps ;
- le métal électroformé comporte du nickel, de l'or ou du platine comme un alliage nickel-phosphore, nickel-tungstène ou nickel-cobalt-phosphore.

De plus, l'invention se rapporte à une pièce d'horlogerie caractérisée en ce qu'elle comprend une pièce selon l'une des variantes précédentes, ladite pièce formant une partie de l'habillage ou une partie du mouvement de la pièce d'horlogerie.

Enfin, l'invention se rapporte à un procédé de fabrication d'une pièce monobloc comportant les étapes suivantes :
a) former un moule sur un substrat électriquement conducteur ;
b) remplir le moule par électroformage afin de former au moins une pièce monobloc métallique ;
c) libérer ladite au moins une pièce monobloc métallique dudit substrat et dudit moule ;
caractérisé en ce que le procédé comporte en outre :
d) réaliser une désorption de l'hydrogène emprisonné dans ladite au moins une pièce monobloc métallique lors de l'électroformage afin de former, uniquement sur une profondeur comprise entre 0,1% et 10% de l'épaisseur totale de la pièce monobloc de toute la surface externe du corps, une autre forme du métal électroformé en apportant un durcissement par rapport au reste du corps.

De manière surprenante, la maîtrise de cette désorption d'hydrogène dans la pièce monobloc métallique obtenue autorise le durcissement de la surface externe de la pièce monobloc métallique obtenue selon une profondeur facilement contrôlable. On comprend donc qu'un front de durcissement à partir de la surface externe vers le centre de la pièce est ainsi réalisé et facilement contrôlé.

Cette possibilité surprenante va à l'encontre du préjugé technique qu'un traitement thermique est toujours homogène, c'est-à-dire que le durcissement est effectif entre la surface externe et le cœur de la pièce, surtout pour des pièces horlogères dont l'épaisseur excède rarement 200 *µ*m.

Conformément à d'autres variantes avantageuses de l'invention :
- le métal est électroformé lors de l'étape b) sous forme amorphe et la surface externe comporte une phase au moins partiellement cristalline du métal électroformé ou une taille de grains supérieure par rapport au métal électroformé lors de l'étape b) ;
- le métal électroformé lors de l'étape b) comporte du nickel, de l'or ou du platine comme un alliage nickel-phosphore, nickel-tungstène ou nickel-cobalt-phosphore ;
- l'étape d) est effectuée sous atmosphère contrôlée à faible pression partielle d'hydrogène comme formée à 95% de diazote et à 5% de dihydrogène à pression atmosphérique ;
- l'étape d) est effectuée sous vide ;
- l'étape d) dure entre 15 et 240 minutes à une température comprise entre 250°C et 450°C.

### Description sommaire des dessins

D'autres particularités et avantages ressortiront clairement de la description qui en est faite ci-après, à titre indicatif et nullement limitatif, en référence aux dessins annexés, dans lesquels :
- les figures 1 à 4 sont des représentations d'étapes du procédé selon l'invention ;
- la figure 5 est un graphique destiné à faire comprendre les conséquences des variations de facteurs de l'étape de désorption du procédé selon l'invention ;
- la figure 6 est une représentation d'applications de l'invention pour l'habillage d'une pièce d'horlogerie ;
- les figures 7 et 8 sont des représentations d'applications de l'invention pour le mouvement d'une pièce d'horlogerie.

### Description détaillée des modes de réalisation préférés

Comme expliqué ci-dessus, les pièces électroformées sont très satisfaisantes quant à leurs cotes, notamment lorsqu'elles sont obtenues par un processus LIGA, mais elles sont généralement trop molles et, incidemment, possèdent une résistance à l'usure qui n'est pas satisfaisante.

Suite à un développement récent qui est mieux expliqué ci-dessous, il a été trouvé de manière surprenante qu'il était possible de durcir la surface externe des pièces électroformées selon une profondeur facilement contrôlable.

Cette possibilité surprenante va à l'encontre du préjugé technique qu'un traitement thermique est toujours homogène, c'est-à-dire que le durcissement est effectif entre la surface externe et le cœur de la pièce, surtout pour des pièces horlogères dont l'épaisseur excède rarement 200 *µ*m.

Or, la pièce monobloc formée d'un corps en métal électroformé comporte, avantageusement selon l'invention, une surface externe qui, uniquement sur une profondeur prédéterminée, comporte un appauvrissement en hydrogène emprisonné en apportant un durcissement par rapport au reste du corps.

En effet, suivant le matériau utilisé, il est possible d'électroformer une pièce métallique peu sensible aux champs magnétiques. Toutefois, le durcissement transformant superficiellement le métal initialement électroformé de manière homogène, présente une forme différente qui peut, elle, être sensible aux champs magnétiques mais également rendre son domaine plastique trop restreint pour autoriser un chassage.

Par conséquent, à l'aide du surprenant durcissement superficiel du corps en métal électroformé, il est ainsi, avantageusement possible selon l'invention, d'améliorer la résistance à l'usure de la pièce monobloc tout en conservant une perméabilité magnétique relative inférieure à 10 et la possibilité d'être chassée.

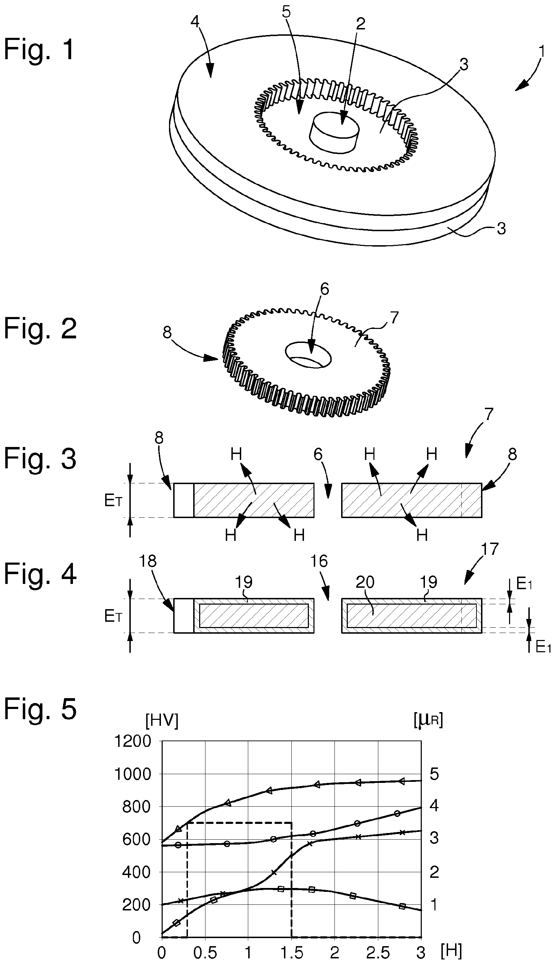

Le procédé de fabrication selon l'invention comporte une première étape a) destinée à former un moule 1 sur un substrat 3 électriquement conducteur comme visible à la figure 1. Le substrat 3 peut indifféremment être intrinsèquement électriquement conducteur comme de l'acier ou du silicium dopé ou être revêtu d'une couche électriquement conductrice comme du verre, de la céramique ou du silicium revêtu d'or et/ou de chrome.

Dans l'exemple illustré à la figure 1, le moule 1 est formé par une résine obtenue par photolithographie formant une partie centrale 2 et une partie périphérique 4 dont l'interstice sera utilisé pour former précisément l'empreinte négative 5 de la future pièce monobloc. Bien entendu, l'avantage d'un tel moule est de ne pas être limité à une seule empreinte 5. Ainsi, plusieurs empreintes 5 peuvent être avantageusement réalisées sur le même substrat, lesdites plusieurs empreintes étant identiques ou non.

Le procédé se poursuit avec une deuxième étape b) destinée à remplir le moule 1 par galvanoplastie afin de former au moins une pièce monobloc métallique. La galvanoplastie sera réalisée en connectant la surface électriquement conductrice du substrat 3 qui forme le fond de l'empreinte négative 5. Préférentiellement, le métal électroformé lors de l'étape b) comporte du nickel, de l'or ou du platine.

De manière encore plus préférée, il est apparu qu'un alliage nickel-phosphore, nickel-tungstène ou nickel-cobalt-phosphore était particulièrement intéressant pour former une pièce horlogère comme une partie de l'habillage ou une partie du mouvement d'une pièce d'horlogerie. Dans l'exemple illustré à la figure 1, l'empreinte négative 5 est en forme de roue.

Le procédé comporte une troisième étape c) destinée à libérer ladite au moins une pièce monobloc métallique 7 du substrat 3 et du moule 1 comme illustré à la figure 2. A cette figure, on peut voir que la pièce monobloc métallique 7 comporte ainsi un trou traversant 6 et une denture 8 formant ainsi une roue. L'étape c) est tributaire du type de substrat 3 utilisé et du type de moule 1 utilisé. Il est généralement utilisé des attaques chimiques sélectives afin de laisser intacte ladite au moins une pièce monobloc métallique 7 obtenue.

Avantageusement selon l'invention, le procédé comporte en outre la dernière étape d) destinée à réaliser une désorption de l'hydrogène emprisonné dans ladite au moins une pièce monobloc métallique lors de l'électroformage de l'étape b). En effet, suite à un développement récent, il a été trouvé que de l'hydrogène était emprisonné lors de l'étape d'électroformage.

Ainsi, de manière surprenante, la maîtrise de cette désorption d'hydrogène dans ladite au moins une pièce monobloc métallique 7 obtenue autorise le durcissement de la surface externe de ladite au moins une pièce monobloc métallique 7 obtenue selon une profondeur facilement contrôlable. On comprend donc qu'un front de durcissement à partir de la surface externe vers le centre de la pièce est ainsi réalisé et facilement contrôlé.

Comme visible à la figure 4, on comprend donc qu'on obtient une pièce 17 composite issue de la pièce 7. Ainsi, la surface externe 19 comporte, uniquement sur une profondeur prédéterminée E₁, une autre forme du métal électroformé en apportant un durcissement par rapport au reste du corps 20 originellement électrodéposé lors de l'étape b). La pièce 17 gardant avantageusement sa forme originelle c'est-à-dire la denture 18 et le trou traversant 16.

Ainsi, il a été montré expérimentalement qu'une profondeur prédéterminée E₁ comprise entre 0,1% et 10% de l'épaisseur totale E_{T} de la pièce 17 monobloc, c'est-à-dire 2.E₁ = 0,1%-10%·E_{T}, donne, de manière surprenante, une pièce dont la résistance à l'usure est augmentée de 30% tout en conservant une perméabilité magnétique relative *µ*_{R} inférieure à 10 et la possibilité d'être chassée.

Suivant le matériau choisi, la surface externe peut consister en une augmentation de la taille de grains par rapport au reste du corps ou en un changement de phase par rapport au reste du corps comme, par exemple, le passage d'une phase amorphe à une phase au moins partiellement cristalline.

Selon l'invention, l'étape d) peut être effectuée sous atmosphère contrôlée à faible pression partielle d'hydrogène ou sous vide afin que l'hydrogène emprisonné s'échappe de la pièce 7. A titre d'exemple nullement limitatif, une atmosphère contrôlée possible pourrait consister un fluide formé à 95% de diazote et à 5% de dihydrogène à pression atmosphérique. Enfin, suivant le matériau utilisé, l'étape d) peut durer entre 15 et 240 minutes à une température comprise entre 250°C et 450 °C.

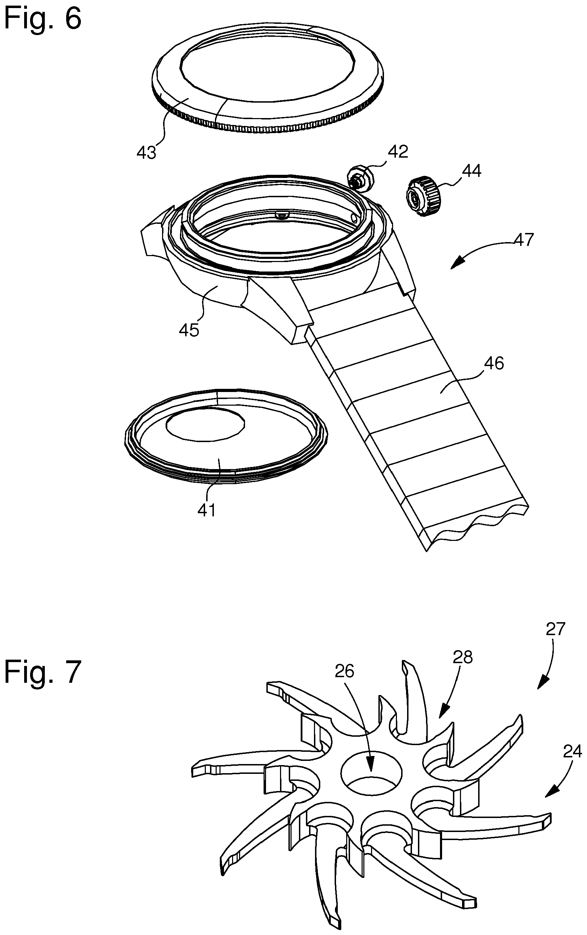

Avantageusement selon l'invention, le front de durcissement à partir de la surface externe vers le centre de la pièce est facilement contrôlé. En effet, la figure 7 illustre un exemple d'application de la présente invention à une roue monobloc coaxiale 27 en nickel-phosphore comportant une denture inférieure 24, une denture supérieure 28 et un trou traversant 26.

Comme visible à la figure 5, les paramètres de l'étape d) ont été modifiés pour construire un graphique montrant leur répercussion sur la pièce monobloc 27. On peut voir, en abscisse, la durée en heure (H) de maintien de l'étape d) réalisée à 300°C réalisée sous une atmosphère contrôlée formée à 95% de diazote et à 5% de dihydrogène à pression atmosphérique. En ordonnées, à gauche, figure la dureté Vickers (HV) et, à droite, la perméabilité magnétique relative (*µ*_{R}).

Le trait annoté en triangle (Δ) représente la dureté Vickers à 10 g de charge (HV0,01), celui annoté en cercle (○) représente la dureté Vickers à 500 g de charge (HV0,5) et celui annoté en carré (□) représente la différence de dureté entre l'essai à 10 g de charge et celui à 500 g de charge. Le trait annoté en croix (X) représente l'évolution de la perméabilité relative *µ*_{R}.

En regardant la courbe annotée en triangle (Δ), on s'aperçoit que la dureté externe de la pièce 27 augmente rapidement au cours de la première heure de désorption sous 300°C puis tend vers une asymptote proche de 1000 HV. En comparaison, la courbe annotée en cercle (○) qui représente la dureté à environ 3 *µ*m de profondeur, est quasiment stable jusqu'à une heure de désorption sous 300°C. On comprendre donc, comme visible à la courbe annotée en carré (□), qu'un front très progressif de transformation est opéré. Il est également visible avec la courbe annotée en carré (□) qu'un extremum, représentant une différence proche de 300 HV, est atteint pour une valeur de 75 minutes de chauffage.

Comme expliqué ci-dessus, le but de la présente invention est d'augmenter la résistance à l'usure tout en conservant une perméabilité magnétique relative *µ*_{R} inférieure à 10 et en gardant la possibilité de chasser la pièce. Une surface délimitée en trait interrompu a été dessinée sur la figure 5 afin de représenter le domaine dans lequel ces conditions sont respectées. On peut voir que la plage de durée de l'étape d) à 300°C présentant un compromis intéressant pour une pièce monobloc 27 en nickel-phosphore s'étend entre 15 et 90 minutes. Bien évidemment, suivant l'application et le matériau utilisé, la plage peut toutefois s'étendre entre 15 et 240 minutes.

Au vu des tests, la durée de 1 heure de l'étape d) à 300°C pour une pièce monobloc 27 en nickel-phosphore semble la plus optimale en ce que la dureté de la surface externe est d'environ 850 HV formée par un front de transformation de phase dendritique qui s'est propagé vers l'intérieur de la pièce au fur et à mesure que l'hydrogène s'échappait alors que la dureté à environ 3 *µ*m de profondeur reste inchangée vers 600 HV formée par une phase amorphe. De plus, la perméabilité relative reste limitée à 1,5 ce qui rend la pièce monobloc très peu sensible aux champs magnétiques. Enfin, après des tests, il est apparu que la pièce monobloc 27 était toujours chassable sur un axe selon les méthodes habituelles pour former des mobiles d'horlogerie.

L'étape d) selon l'invention est différente d'un traitement thermique habituel des métaux qui est généralement réalisé autour de 200°C afin de relaxer les contraintes internes. A titre d'exemple, les phénomènes décrits ci-dessus se produisent, dans le cas du nickel-phosphore uniquement pour des températures sensiblement supérieures à 250°C.

Bien entendu, la présente invention ne se limite pas à l'exemple illustré mais est susceptible de diverses variantes et modifications qui apparaîtront à l'homme de l'art. En particulier, le même test doit être réalisé suivant l'application, la température, le matériau utilisé et la durée de l'étape d) afin de déterminer les paramètres optimaux de la pièce à fabriquer.

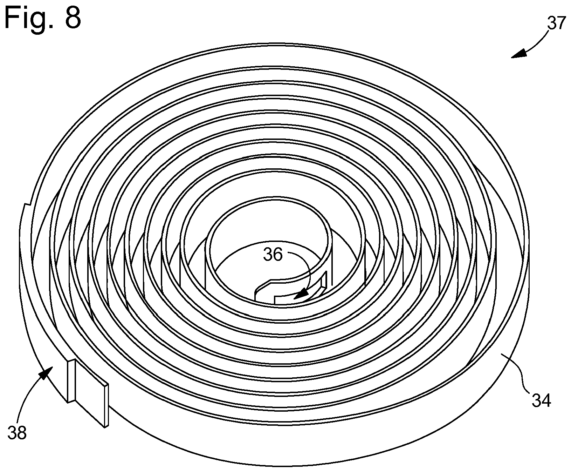

A titre d'exemple illustré à la figure 8, un ressort d'horlogerie, tel qu'un ressort-moteur 37, n'a pas à être chassé comme un mobile mais uniquement emmanché par son œillet 36 au crochet de la bonde de l'arbre de barillet (non représenté). A ce titre, il peut certainement faire l'objet d'une étape d) de plus longue durée, c'est-à-dire par exemple comprise entre 90 et 240 minutes, afin de fournir une réserve de marche plus élevée à la pièce d'horlogerie. De plus, le ressort-moteur 37 étant électroformé, la lame 34 peut avoir une section variable destinée à fournir un couple élastique sensiblement constant pendant la détente du ressort-moteur 37 et/ou comporter une bride 38 monobloc avec la lame 34.

De manière similaire et comme illustré à la figure 6, l'application de la présente invention n'est pas limitée à une partie d'un mouvement d'horlogerie mais peut également être avantageusement appliquée notamment à l'habillage d'une pièce d'horlogerie. En effet, si le fond 41 et la lunette 43 d'une pièce d'horlogerie sont généralement chassés, ce n'est pas le cas de la carrure 45, du bracelet 47, du poussoir 42 ou de la couronne 44.

Ainsi, de manière non limitative, la carrure 45 ou les maillons 46 du bracelet 47 peuvent certainement faire l'objet d'une étape d) de plus longue durée, c'est-à-dire par exemple comprise entre 90 et 240 minutes, afin de fournir une résistance à l'usure plus élevée pour que la pièce d'horlogerie se marque moins au porter.

Le procédé est également susceptible d'être adapté sans sortir du cadre de l'invention. Ainsi, il est envisageable de déposer un volume sacrificiel dans le trou 6 avant l'étape d) permettant de limiter l'avancée du front de durcissement au niveau de la paroi du trou 16, 26 et ainsi rendre encore plus facile le futur chassage de la pièce monobloc 17, 27.

## Revendications

1. Pièce monobloc (17, 27, 37, 41, 42, 43, 44, 45, 47) comportant un corps en métal électroformé comportant de l'hydrogène emprisonné **caractérisée en ce que** toute la surface externe (19) du corps comporte, uniquement sur une profondeur (E₁) comprise entre 0,1% et 10% de l'épaisseur totale (E_{T}) de la pièce monobloc (17, 27, 37, 41, 42, 43, 44, 45, 47), un appauvrissement en hydrogène emprisonné apportant un durcissement par rapport au reste du corps afin d'améliorer la résistance à l'usure de la pièce monobloc (17, 27, 37, 41, 42, 43, 44, 45, 47) tout en conservant une perméabilité magnétique relative (*µ*_{R}) inférieure à 10 et la possibilité d'être chassée.

2. Pièce (17, 27, 37, 41, 42, 43, 44, 45, 47) selon la revendication 1, **caractérisée en ce que** le métal est électroformé sous forme amorphe et la surface externe (19) comporte une phase au moins partiellement cristalline du métal électroformé.

3. Pièce (17, 27, 37, 41, 42, 43, 44, 45, 47) selon la revendication 1, **caractérisée en ce que** la surface externe (19) comporte une taille de grains supérieure au métal électroformé du reste du corps.

4. Pièce (17, 27, 37, 41, 42, 43, 44, 45, 47) selon l'une des revendications précédentes, **caractérisée en ce que** le métal électroformé est un alliage nickel-phosphore, nickel-tungstène ou nickel-cobalt-phosphore.

5. Pièce d'horlogerie **caractérisée en ce qu'**elle comprend une pièce monobloc (17, 27, 37, 41, 42, 43, 44, 45, 47) selon l'une des revendications précédentes.

6. Pièce d'horlogerie selon la revendication 5, **caractérisée en ce que** ladite pièce monobloc forme une partie de l'habillage de ladite pièce d'horlogerie.

7. Pièce d'horlogerie selon la revendication 5, **caractérisée en ce que** ladite pièce monobloc forme une partie du mouvement de ladite pièce d'horlogerie.

8. Procédé de fabrication d'une pièce monobloc (17, 27, 37, 41, 42, 43, 44, 45, 47) comportant un corps en métal électroformé comportant de l'hydrogène emprisonné, le procédé comportant les étapes suivantes :
a) former un moule (1) sur un substrat (3) électriquement conducteur ;
b) remplir le moule (1) par électroformage afin de former au moins une pièce (6) monobloc métallique ;
c) libérer ladite au moins une pièce monobloc métallique dudit substrat et dudit moule ;
**caractérisé en ce que** le procédé comporte en outre l'étape suivante :
d) réaliser une désorption de l'hydrogène emprisonné dans ladite au moins une pièce monobloc métallique lors de l'électroformage afin de former, uniquement sur une profondeur (E₁) comprise entre 0,1% et 10% de l'épaisseur totale (E_{T}) de la pièce monobloc (17, 27, 37, 41, 42, 43, 44, 45, 47) de toute la surface externe (19) du corps, un durcissement par rapport au reste du corps.

9. Procédé selon la revendication 8, **caractérisé en ce que** le métal est électroformé lors de l'étape b) sous forme amorphe et la surface externe comporte une phase au moins partiellement cristalline du métal électroformé.

10. Procédé selon la revendication 8, **caractérisé en ce que** la surface externe comporte une taille de grains supérieure par rapport au métal électroformé lors de l'étape b).

11. Procédé selon l'une des revendications 8 à 10, **caractérisé en ce que** le métal électroformé lors de l'étape b) est un alliage nickel-phosphore, nickel-tungstène ou nickel-cobalt-phosphore.

12. Procédé selon l'une des revendications 8 à 11, **caractérisé en ce que** l'étape d) est effectuée sous atmosphère contrôlée à faible pression partielle d'hydrogène.

13. Procédé selon la revendication précédente, **caractérisé en ce que** l'atmosphère contrôlée est formée à 95% de diazote et à 5% de dihydrogène à pression atmosphérique.

14. Procédé selon l'une des revendications 8 à 11, **caractérisé en ce que** l'étape d) est effectuée sous vide.

15. Procédé selon l'une des revendications 8 à 14, **caractérisé en ce que** l'étape d) dure entre 15 et 240 minutes à une température comprise entre 250°C et 450°C.

## Patentansprüche

1. Formkörper (17, 27, 37, 41, 42, 43, 44, 45, 47), umfassend einen durch Galvanoformung erzeugten Metallkörper, der eingeschlossenen Wasserstoff enthält, **dadurch gekennzeichnet, dass** die gesamte Außenfläche (19) des Körpers eine eingeschlossene Wasserstoffarmut nur bis zu einer Tiefe (E₁), die zwischen 0,1 % und 10 % der Gesamtdicke (E_{T}) des Formkörpers (17, 27, 37, 41, 42, 43, 44, 45, 47) liegt, aufweist, die eine Härtung im Vergleich zum Restkörper bewirkt, um die Verschleißfestigkeit des Formkörpers (17, 27, 37, 41, 42, 43, 44, 45, 47) zu verbessern und dabei gleichzeitig eine relative magnetische Permeabilität (µ_{R}) von weniger als 10 und die Möglichkeit des Einpressens aufrechtzuerhalten.

2. Teil (17, 27, 37, 41, 42, 43, 44, 45, 47) nach Anspruch 1, **dadurch gekennzeichnet, dass** das Metall durch Galvanoformung in amorpher Form erzeugt wird und dass die Außenfläche (19) eine mindestens teilweise kristalline Phase des durch Galvanoformung erzeugten Metalls aufweist.

3. Teil (17, 27, 37, 41, 42, 43, 44, 45, 47) nach Anspruch 1, **dadurch gekennzeichnet, dass** die Außenfläche (19) eine Teilchengröße aufweist, die größer ist als das durch Galvanoformung erzeugte Metall des Restkörpers.

4. Teil (17, 27, 37, 41, 42, 43, 44, 45, 47) nach einem der vorhergehenden Ansprüche, **dadurch gekennzeichnet, dass** das durch Galvanoformung erzeugte Metall eine Nickel-Phosphor-, Nickel-Wolfram- oder Nickel-Kobalt-Phosphor-Legierung ist.

5. Uhr, **dadurch gekennzeichnet, dass** sie einen Formkörper (17, 27, 37, 41, 42, 43, 44, 45, 47) nach einem der vorhergehenden Ansprüche umfasst.

6. Uhr nach Anspruch 5, **dadurch gekennzeichnet, dass** der Formkörper einen Teil der Verkleidung der Uhr bildet.

7. Uhr nach Anspruch 5, **dadurch gekennzeichnet, dass** der Formkörper einen Teil des Uhrwerks der Uhr bildet.

8. Verfahren zur Herstellung eines Formkörpers (17, 27, 37, 41, 42, 43, 44, 45, 47), umfassend einen durch Galvanoformung erzeugten Metallkörper, der eingeschlossenen Wasserstoff enthält, wobei das Verfahren die folgenden Schritte umfasst:
a) Bilden einer Form (1) auf einem elektrisch leitfähigen Substrat (3);
b) Füllen der Form (1) durch Galvanoformen zum Bilden mindestens eines metallischen Formkörpers (6);
c) Freigeben des mindestens einen metallischen Formkörpers des Substrats und der Form;
**dadurch gekennzeichnet, dass** das Verfahren ferner folgenden Schritt umfasst:
d) Vornehmen einer Desorption des in dem mindestens einen metallischen Formkörper während der Galvanoformung eingeschlossenen Wasserstoffs zum Bilden einer Härtung im Vergleich zum Restkörper nur bis zu einer Tiefe (E₁), die zwischen 0,1 % und 10 % der Gesamtdicke (E_{T}) des Formkörpers (17, 27, 37, 41, 42, 43, 44, 45, 47) der gesamten Außenfläche (19) des Körpers liegt.

9. Verfahren nach Anspruch 8, **dadurch gekennzeichnet, dass** das Metall während Schritt b) in amorpher Form durch Galvanoformung erzeugt wird und die Außenfläche eine mindestens teilweise kristalline Phase des durch Galvanoformung erzeugten Metalls aufweist.

10. Verfahren nach Anspruch 8, **dadurch gekennzeichnet, dass** die Außenfläche eine Teilchengröße aufweist, die größer ist als das in Schritt b) durch Galvanoformung erzeugte Metall.

11. Verfahren nach einem der Ansprüche 8 bis 10, **dadurch gekennzeichnet, dass** das in Schritt b) durch Galvanoformung erzeugte Metall eine Nickel-Phosphor-, Nickel-Wolfram- oder Nickel-Kobalt-Phosphor-Legierung ist.

12. Verfahren nach einem der Ansprüche 8 bis 11, **dadurch gekennzeichnet, dass** Schritt d) unter kontrollierter Atmosphäre bei niedrigem Wasserstoffpartialdruck durchgeführt wird.

13. Verfahren nach dem vorhergehenden Anspruch, **dadurch gekennzeichnet, dass** die kontrollierte Atmosphäre zu 95 % durch Distickstoff und zu 5 % durch Dihydrogen bei atmosphärischem Druck gebildet wird.

14. Verfahren nach einem der Ansprüche 8 bis 11, **dadurch gekennzeichnet, dass** Schritt d) unter Vakuum durchgeführt wird.

15. Verfahren nach einem der Ansprüche 8 bis 14, **dadurch gekennzeichnet, dass** Schritt d) bei einer Temperatur zwischen 250 °C und 450 °C zwischen 15 und 240 Minuten dauert.

## Claims

1. One-piece component (17, 27, 37, 41, 42, 43, 44, 45, 47) including an electroformed metal body comprising trapped hydrogen, **characterized in that** the entire external surface (19) of the body includes, only to a predetermined depth (E₁) that lies in the range 0.1% to 10% of the total thickness (E_{T}) of the one-piece component (17, 27, 37, 41, 42, 43, 44, 45, 47), a depletion of trapped hydrogen causing a hardening relative to the rest of the body in order to improve the wear resistance of the one-piece component (17, 27, 37, 41, 42, 43, 44, 45, 47) while preserving a relative magnetic permeability (*µ*_{R}) of less than 10 and the ability to be driven.

2. Component (17, 27, 37, 41, 42, 43, 44, 45, 47) according to claim 1, **characterized in that** the metal is electroformed in amorphous form and the external surface (19) has an at least partially crystalline phase of the electroformed metal.

3. Component (17, 27, 37, 41, 42, 43, 44, 45, 47) according to claim 1, **characterized in that** the external surface (19) has a larger grain size than the electroformed metal of the rest of the body.

4. Component (17, 27, 37, 41, 42, 43, 44, 45, 47) according to any of the preceding claims, **characterized in that** the electroformed metal is a nickel-phosphorus, nickel-tungsten or nickel-cobalt-phosphorus alloy.

5. Timepiece **characterized in that** the timepiece includes a one-piece component (17, 27, 37, 41, 42, 43, 44, 45, 47) according to any of the preceding claims.

6. Timepiece according to claim 5, **characterized in that** said one-piece component forms part of the exterior of said timepiece.

7. Timepiece according to claim 5, **characterized in that** said one-piece component forms part of the movement of said timepiece.

8. Method for fabricating a one-piece component (17, 27, 37, 41, 42, 43, 44, 45, 47) including an electroformed metal body comprising trapped hydrogen, the method comprising the following steps:
a) forming a mould (1) on an electrically conductive substrate (3);
b) filling the mould (1) by electroforming to form at least one one-piece metal component (6);
c) releasing said at least one one-piece metal component from said substrate and from said mould;
**characterized in that** the method further includes the step of:
d) effecting desorption of the trapped hydrogen in said at least one one-piece metal component during electroforming so as to form, only to a predetermined depth (E₁) that lies in the range 0.1% to 10% of the total thickness (E_{T}) of the one-piece component (17, 27, 37, 41, 42, 43, 44, 45, 47) of the entire external surface (19) of the body, a hardening relative to the rest of the body.

9. Method according to claim 8, **characterized in that** the metal is electroformed in step b) in amorphous form and the external surface includes an at least partially crystalline phase of the electroformed metal.

10. Method according to claim 8, **characterized in that** the external surface includes a larger grain size than the metal that is electroformed in step b).

11. Method according to any of claims 8 to 10, **characterized in that** the metal electroformed in step b) is a nickel-phosphorus, nickel-tungsten or nickel-cobalt-phosphorus alloy.

12. Method according to any of claims 8 to 11, **characterized in that** step d) is performed in a controlled atmosphere with low partial pressure of hydrogen.

13. Method according to the preceding claim, **characterized in that** the controlled atmosphere is formed of 95% dinitrogen and 5% dihydrogen at atmospheric pressure.

14. Method according to any of claims 8 to 11, **characterized in that** step d) is performed in a vacuum.

15. Method according to any of claims 8 to 14, **characterized in that** step d) lasts between 15 and 240 minutes at a temperature comprised between 250°C and 450°C.
